# EUROPEAN PATENT SPECIFICATION

(11) **EP 2 137 759 B1**
(45) Date of publication and mention of the grant of the patent: **20.02.2019**
(21) Application number: 08736152.3
(22) Date of filing: 11.04.2008
(51) Int. Cl.: H01L 21/311, H01L 21/321, H01L 21/02, C09G 1/02, C11D 3/39, C11D 11/00

(54) **USE OF OXIDANTS FOR THE PROCESSING OF SEMICONDUCTOR WAFERS, AND COMPOSITION THEREFORE**
VERWENDUNG VON OXIDATIONSMITTELN ZUM VERARBEITEN VON HALBLEITERWAFERN, UND ZUSAMMENSETZUNG DAFÜR
UTILISATION D'OXYDANTS POUR LE TRAITEMENT DE PLAQUETTES DE SEMICONDUCTEURS, ET COMPOSITION ASSOCIÉE

(30) Priority: 13.04.2007 EP 07106168
(43) Date of publication of application: 30.12.2009
(73) Proprietor: SOLVAY SA, 1120 Bruxelles (BE)
(72) Inventor: BOSSE, Jürgen, NEUSTADT AM RBG 31535 (DE); ALESSIO, Rocco, I-MIGLIARINO PISA 56010 (IT); DOBSON, Steve, B-3090 Jezus-Eik (BE); BELT, Heinz-Joachim, 30938 Burgwedel (DE)
(74) Representative: Mross, Stefan P.M.
(86) International application number: PCT/EP2008/054443
(87) International publication number: WO 2008/125638

(56) References cited:
- EP-A- 1 095 992
- EP-A2- 0 788 143
- WO-A-95/34537
- WO-A-2004/007452
- US-A- 6 037 002
- US-A1- 2002 121 156
- US-A1- 2005 178 742
- US-A1- 2005 261 151
- US-A1- 2006 254 615

## Description

The present invention relates to the use of oxidants in compositions for the processing of semiconductor wafers, wherein the processing contains cleaning and chemical mechanical polishing of semiconductor wafers. The present invention also relates to a composition in the form of a slurry.

The processing of those semiconductor wafers and metal layers frequently requires the use of cleaning compositions to remove contaminants such as organics, small particles, heavy metals and other residues from the surface of the semiconductor wafers and metal layers.

Chemical mechanical planarization (CMP) processes are also commonly used in the semiconductor industry. Indeed, the surface of semiconductor wafer, dielectric layer, conducting wire and barrier materials in the integrated circuits has to be polished to achieve a certain degree of planarity, which is extremely important to reach a high density of integrated circuits. For example, CMP is frequently used to planarize semiconductor substrates after the deposition of the metal interconnect layers.

It is known to use cleaning and CMP compositions containing hydrogen peroxide as oxidant. Unfortunately, the use of such compositions may lead to corrosion of the surface of semiconductor wafers and metal layers. Cleaning and CMP compositions, as well as cleaning and CMP methods, have thus been developed to inhibit the corrosion during semiconductor wafer processing.

For example, US patent application No. 2002/0020432 discloses a method for the cleaning of a semiconductor wafer surface preventing the silicide layer covering the semiconductor wafer from corroding by using a classical cleaning solution based on hydrogen peroxide, ammonia and water while controlling the temperature of the wafer (between room temperature and 45°C) and of the cleaning solution (between 0 and 45°C).

It is also known to add corrosion inhibiting compounds to the compositions. For example, US patent application No. 2005/0261151 discloses aqueous corrosion-inhibiting cleaning compositions for semiconductor wafer processing based on hydrogen peroxide and containing an azole compound which acts as a chelating agent that binds with and inhibits corrosion of metal layers being cleaned.

Notwithstanding these known cleaning and CMP compositions for semiconductor wafer processing, there continues to be a need for cleaning and CMP compositions showing good efficacy while limiting/avoiding the corrosion of the substrate. Indeed, the corrosivity of hydrogen peroxide based compositions to the surface of the semiconductor wafers and metal layers, particularly to silicon, is becoming more and more an issue. Furthermore, the use of compositions based on hydrogen peroxide raises issues with regard to composition stability as well as with cleaning and polishing performances in CMP.

The purpose of the present invention is to provide new oxidants for formulating new compositions for the processing of semiconductor wafers which show good cleaning and/or polishing efficacy while limiting/avoiding the corrosion of the substrate.

The present invention therefore relates to the use of at least one oxidant in compositions for semiconductor wafer processing as defined in claim 1. The present invention also relates to a composition in the form of a slurry as defined in claim 10.

One of the essential features of the present invention resides the reduction of the amount of hydrogen peroxide used in the processing of semiconductor wafers without impairing the efficacy of such processing. This is achieved by using peracids selected from the group consisting of ester peracids of formula (II) and/or imido-alkane-percarboxylic acids of formula (I), to replace the totality or at least a part of the hydrogen peroxide usually used in semiconductor wafer processing compositions, hereby making it possible to lower the concentration in hydrogen peroxide compared to classical compositions. It has indeed been found that peracids are effective oxidants for semiconductor wafer processing. It has also been found that peracids lead to a lower corrosion of the substrate compared to hydrogen peroxide. Furthermore, it has been found that peracids allow the preparation of semiconductor wafer processing compositions with an extended shelf life compared to the ones containing exclusively hydrogen peroxide as oxidant.

The term "peracid" means a compound containing at least one -COOOH group.

The peracid present in the semiconductor wafer processing composition according to the invention can be the single oxidant present. The peracid can also be present in combination with other usual oxidants, for example hydrogen peroxide. Preferably, the peracid is used in combination with hydrogen peroxide.

Depending on its intended use, the peracid may be present in the composition in an amount of at least 0.01 % w/w, particularly at least 0.1% w/w, for example about 1% w/w. The peracid is in general present in the composition in an amount of at most 40 % w/w, preferably at most 30% w/w, for example about 20% w/w.

In the present invention, the total amount of oxidant present in the composition used in the semiconductor wafer processing is usually of from 0.01 to 40 % w/w.

The composition used in the present invention is usually liquid. Liquid compositions can be aqueous. Alternatively, they can be non aqueous. Liquid compositions can be solutions or suspensions.

The shelf life of compositions containing peracids is usually higher than the shelf life of compositions containing hydrogen peroxide as sole oxidant. This statement is further illustrated below.

According to the present invention, the peracid is selected from the group consisting of imido-alkane-percarboxylic acids of formula (I) and ester peracids of formula (II).

Imido-alkane-percarboxylic acids are disclosed for instance in the European patent application EP 0 325 288 owned by SOLVAY SOLEXIS S.p.A and in the international patent application WO 2004/007452 filed by SOLVAY SOLEXIS S.pA.

The imido-alkane-percarboxylic acids have the general formula (I): 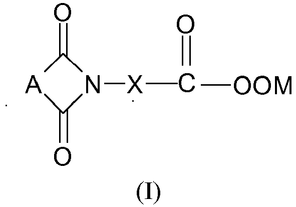 wherein: A represents a group chosen from the following: 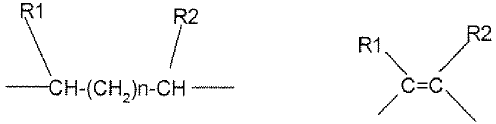 or 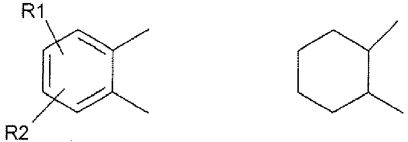 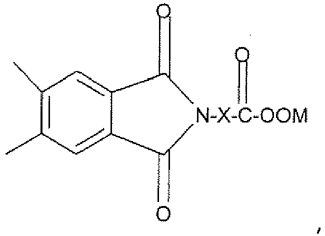 in which:
n is an integer 0, 1 or 2,
R1 has one of the following meanings: hydrogen, chlorine, bromine, C₁-C₂₀ alkyl, C₂-C₂₀ alkenyl, aryl or alkylaryl,
R2 is hydrogen, chlorine, bromine or a group chosen from the following: -SO₃M, -CO₂M, -CO₃M or -OSO₃M,
M means hydrogen, an alkali metal, ammonium or an equivalent of an alkaline-earth metal,
X indicates a C₁-C₁₉ alkylene or an arylene.

Said peracids are in most cases soluble in alcohols and other organic solvents, such as ethers, esters, ketones and halogenated solvents, especially chlorinated solvents. For example, the organic solvent may be acetone, tetrahydrofurane (THF), ethylacetate, or ethyllactate. They are also very often soluble in water, especially at a pH above 7. Depending on the pH of the composition, they can thus be used in the form of solutions or slurries. In this latter case, further to their oxidizing properties, these products, also exhibit some abrasive properties.

The shelf life of compositions containing imido-alkane-percarboxylic acids is usually higher than the shelf life of compositions containing hydrogen peroxide as sole oxidant.

Said imido-alkane-percarboxylic acids are generally available as stable solid materials, with no particular odor. A further advantage is their biodegradability as they decompose into biodegradable products with negligible aquatic toxicity.

More preferably, the imido-alkane-percarboxylic acid is ε-phtalimido-peroxycaproic acid (called PAP). PAP is, for example, sold by SOLVAY SOLEXIS S.p.A. under the trademark EURECO®.

Ester peracids are disclosed for instance in the European patent applications EP 0 765 309, 0 946 506 and 1 089 971 filed by SOLVAY INTEROX LIMITED.

Ester peracids useful in the present invention have the general formula (II): 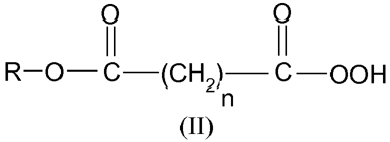 wherein R represents an alkyl group having 1 to 4 carbon atoms and n is from 1 to 4. When R has 3 or 4 carbons, the alkyl group can be linear or branched, i.e. the alkyl group can be n- or isopropyl, or n-, iso- or tertiary butyl.

Preferably, R is a methyl group. In many cases, n is 2, 3, and 4, i.e. a mixture of the monoesters of peradipic, perglutaric and persuccinic acids. More preferably, the major component of the mixture has n equal to 3. Such ester peracids are, for example, a mixture of the methyl monoesters of peradipic, perglutaric and persuccinic acids, the major component of the mixture being the methyl monoester of perglutaric acid. Such ester peracids are sold by SOLVAY INTEROX LIMITED under the trademark PERESTANE®.

Such ester peracids are usually used dissolved in water, polar solvent or mixture thereof, leading to storage stable equilibrium systems with good handling and stability properties. These equilibrium systems comprise the corresponding diester, ester acid, diacid, acid peracid and diperacid. Such systems usually have a pH in the range of from 1 to 5. The total concentration of ester peracids in the equilibrium solution is usually of from 2 to about 10% by weight of the solution, preferably from about 3 to about 6% by weight. Hydrogen peroxide is also typically present in the equilibrium solutions at a concentration of up to 30% by weight, with concentrations in the range of from 5 to 25%, for example from 10 to 20% by weight.

Such equilibrium systems containing ester peracids usually present a higher stability compared to compositions containing solely hydrogen peroxide as oxidant.

Further to their advantages towards the limitation of corrosion and the enhanced shelf life of the compositions containing them compared with hydrogen peroxide based compositions, the imido-alkane-percarboxylic acids and the ester peracids cited above have the advantage not to present an intense odor, like many other peracids.

In a first embodiment of the present invention, the semiconductor wafer processing contains wafer cleaning. The wafer cleaning is usually conducted by bringing the composition into contact with the surface of the semiconductor wafer. The purpose of the cleaning is to remove contaminants such as organics, small particles, heavy metals and other residues from the surface of the semiconductor wafer and metal layers. For example, solvent based cleaning compositions can be used to remove post-etch photoresist layers from low-k dielectric materials.

According to the first embodiment, the semiconductor wafer can be cleaned using any conventional methods of cleaning semiconductors using cleaning solutions, including dipping, showering and spraying techniques. A useful apparatus for the cleaning can for example be a wet batch cleaning apparatus, including one or more water tanks filled with cleaning solutions.

The cleaning carried out in the first embodiment can be conducted in a single step or more. It can further comprise a mechanical cleaning step. Mechanical cleaning includes brush-scrub cleaning, for example with a highspeed rotation brush, and ultrasonic cleaning using high frequency. The cleaning step is usually followed by a rinsing and/or a drying step.

Usually, compositions used in the first embodiment for semiconductor wafer cleaning are in the form of a solution, preferably of an aqueous solution or a solution into an organic solvent. Depending on the intended use, an aqueous solution, an solution into an organic solvent, or a mixture of both may be preferred. For example, the organic solvent may be selected from alcohols, ethers, esters, ketones, and/or halogenated solvents. Suitable examples are acetone, tetrahydrofurane (THF), ethylacetate, or ethyllactate.

The pH of the cleaning composition used in the first embodiment can usually vary from 1 to 13. The pH of the cleaning composition will indeed vary with the nature of the peracid chosen. Sometimes, the pH needs to be adapted to the solubility of the peracid chosen.

The pH of the composition may be adjusted with an acid or a base. Acids include any mineral acids such as sulfuric acid, hydrochloric acid, phosphoric acid and nitric acid, or organic acids such as acetic acid. The base is usually an alkaline metal hydroxide, such as sodium or potassium hydroxide, ammonia, or an organic amine. The pH can also be maintained by adding a buffer solution.

The operating temperature at which the cleaning step is conducted in the first embodiment is usually of from 0 to 100°C, preferably of from 40 to 70°C. The duration of the cleaning step in the first embodiment is usually at least 10 seconds, preferably at least 30 seconds, more preferably at least 1 minute. The duration of the cleaning step in the first embodiment is in general at most 30 minutes, especially at most 20 minutes, more particularly at most 10 minutes.

In a second embodiment of the present invention, the semiconductor wafer processing contains chemical mechanical planarization (CMP) of a surface. Practically, CMP comprises bringing the composition into contact with the surface to be polished and polishing the surface causing a friction between the surface to be polished and a polishing surface. The purpose of the CMP is to make the surface planar. Indeed, the surface of semiconductor wafer, dielectric layer, conducting wire and barrier materials in the integrated circuits have to be polished to achieve a certain degree of planarity, which is extremely important to reach a high density of integrated circuits. For example, CMP is frequently used to planarize semiconductor substrates after the deposition of the metal interconnect layers.

According to the second embodiment of the present invention, CMP can be conducted on metal layers on semiconductor substrates. The metal can be aluminum, copper, tungsten, gold, silver, platinum, nickel, or titan, as well as alloys thereof and mixtures thereof. The metal is preferably aluminum or copper, more preferably copper. The metal layer can form a wiring or a plug.

As an apparatus for the CMP step according to the second embodiment, use can be made of a general polishing apparatus having a holder which holds a work piece having a surface to be polished and a polishing surface plate having a polishing pad attached thereto (and equipped with a motor capable of changing in rotation speed). The polishing pad is not particularly limited and use can be made, for example, of general nonwoven fabrics, foamed polyurethanes, porous fluororesins, and the like.

The CMP process carried out in the second embodiment can be conducted in one single step or more. It can also be conducted as a two stage process, in which the second stage corresponds to a cleaning of the substrate. Usually, each CMP stage is followed by a cleaning stage.

Usually, compositions used in the second embodiment for semiconductor wafer CMP are in the form of slurries, preferably of aqueous slurries or slurries into an organic solvent.

It can be advantageous to adjust the pH of the CMP composition used in the second embodiment with regard to the material to be polished. The pH of the composition may be adjusted with an acid or a base, as detailed above.

Usually, CMP compositions used in the second embodiment can further comprise abrasive particles. Abrasive particles are in general present in an amount of at least 0,01% w/w, preferably at least 0,1% w/w, more preferably at least 0,5% w/w, in particular at least 1% w/w. Generally, abrasive particles are present in an amount of at most 60% w/w, with particular preference at most 30% w/w, with higher preference at most 20% w/w, for example at most 15% w/w. The abrasive particles can be inorganic, polymeric, or non-polymeric organic particles. Usual abrasive particles are, for example, alumina, silica, zirconium oxide, magnesium oxide, cerium oxide and other materials. Both the mechanical action of the abrasive particles and the chemical action of the slurry remove material from the wafer source.

The preferred CMP conditions according to the second embodiment of the invention depends on the particular CMP apparatus employed.

The manufacture of many types of work pieces requires the substantial planarization or polishing of at least one surface of the work piece. Examples of such work pieces that require a planar surface include semiconductor components, but also optical components, ceramics, memory disks, and the like. The present application can of course also be applied to the CMP of such work pieces and is therefore also related to the use of a composition comprising at least one oxidant selected from peracids for chemical mechanical planarization.

In a third embodiment of the present invention, the semiconductor wafer processing composition further comprises at least one material selected from chelating agents, stabilizing agents, dispersing agents, corrosion inhibitors, surfactants, thickeners, pH controllers or mixtures thereof.

Examples of chelating agents are described, for example, in US patent application No. 2006/0073997 (from page 2, paragraph [0035] to page 3, paragraph [0044]), in US patent application No. 2005/0005525 (page 4, paragraphs [0048]) and in European patent application EP 1 642 949 (page 15, paragraphs [0084]).

Dispersing agents and surfactants can be nonionic, anionic, cationic and amphoteric. Examples of useful dispersing agents and surfactants are described, for example, in US patent application No. 2005/0005525 (page 3, paragraphs [0037] to [0040]) and in European patent application EP 1 642 949 (page 15, paragraph [0091] to page 16, paragraph [0097]).

Useful corrosion inhibitors (passivation agents) are, for example, described in US patent applications No. 2005/0261151 (page 2, paragraph [0015]), in US patent application No. 2005/0005525 (page 4, paragraphs [0050] to [0051]) and in European patent application EP 1 642 949 (page 4, paragraph [0036] to page 13, paragraph [0064]). The corrosion inhibitor is preferably an azole, for example benzotriazole.

As explained above, pH controllers may be an acid or a base. Acids include any mineral acids such as sulfuric acid, hydrochloric acid, phosphoric acid and nitric acid, or organic acids such as acetic acid. The base is usually an alkaline metal hydroxide, such as sodium or potassium hydroxide, ammonia, or an organic amine. The pH can also be maintained by adding a buffer solution. Examples of buffer solutions are described in EP patent application No. 1 642 949 (page 16, paragraph [0099] to page 17, paragraph [0100]).

The present invention is further illustrated below without limiting the scope thereto.

### Examples 1-4: Photoresist dissolution tests

Photoresist dissolution tests were conducted on pristine blanket photoresist (PR, methacrylate-based resins with adamantane and lactone as side-chain groups, 193 nm) on Black Diamond I (BDI, k = 3,0, 6-8% porosity) in the presence of various organic solvents and optionally in the presence of 1% by weight of ε-phtalimido-peroxycaproic acid as peracid. Table 1 below summarizes the time necessary for the complete removal of the photoresist layer.

**Table 1**

| | Solvent | Without peracid | With 1% peracid |
|---|---|---|---|
| 1 | Acetone | < 2 min | < 2 min |
| 2 | THF | 10 min | 10 min |
| 3 | Ethylacetate | 10 min | 10 min |
| 4 | Ethyllactate | 10 min | 5 min |

### Examples 2-8: Photoresist wet strip removal on Black Diamond I

Photoresist wet strip removal experiments were conducted on plasma-treated Single Damascene Black Diamond I (SD BDI, k = 3,0, 6-8% porosity) covered with a photoresist layer consisting of a methacrylate-based resins with adamantane and lactone as side-chain groups (PR, 193 nm). The purpose was to test the removal of post-etch photoresist. The etching was performed with an O₂, Ar, CF₄, and CH₂F₂ reactive ion etch (RIE) plasma. The dielectric height was 240 nm. The tests were conducted during 10 minutes, in the presence of ultrasonic waves. The removal efficiency was assessed using optical microscope inspection. The conclusions of the tests are summarized in the table 2 below.

**Table 2**

| | Solvent | Solvent only | With 1% peracid |
|---|---|---|---|
| 5 | Acetone | Partial PR removal | Complete PR removal |
| 6 | THF | Partial PR removal | Partial PR removal |
| 7 | Ethylacetate | Partial PR removal | Complete PR removal |
| 8 | Ethyllactate | Complete PR removal Damages | Complete PR removal No damages |

### Examples 9-12: Photoresist wet strip removal on Nano Clustered Silica

Photoresist wet strip removal experiments were conducted on Single Damascene Nano Clustered Silica (SD NCS, k = 2,5, 30% porosity) covered with a tantalum nitride metal hard mask, a bottom antireflective coating layer (BARC, 193 nm), and a photoresist layer consisting of a methacrylate-based resins with adamantane and lactone as side-chain groups (PR, 193 nm). The etching was performed with a three step reactive ion etch (RIE) plasma: HBr (photoresist hardening), HBr/O₂ mixture (BARC opening), and Cl₂ (TaN etch). The dielectric height was 190 nm. The tests were conducted during 10 minutes at 20°C and 40°C, in the presence of ultrasonic waves. The removal efficiency was assessed using optical microscope inspection. The conclusions of the tests are summarized in the table 3 below.

**Table 3**

| | Solvent | Temperature | Solvent only | With 1% peracid |
|---|---|---|---|---|
| 9 | Acetone | 20°C | Partial PR removal | Partial PR removal |
| 10 | THF | 20°C | Partial PR removal | Improved PR removal |
| 11 | Ethyllactate | 20°C | Partial PR removal | Improved PR removal |
| 12 | THF | 40°C | Partial PR removal | Partial PR removal |

## Claims

1. Use of at least one oxidant selected from the group consisting of ester peracids and imido-alkane-percarboxylic acids in compositions for semiconductor wafer processing, wherein the ester peracid has the following formula: 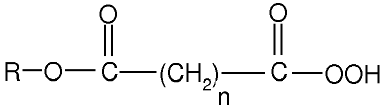 wherein:
R represents an alkyl group having 1 to 4 carbon atoms and
n is from 1 to 4;
wherein the imido-alkane-percarboxylic acid has the following formula: 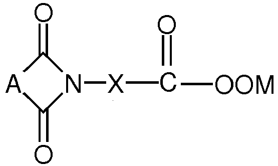 wherein: A represents a group chosen from the following: 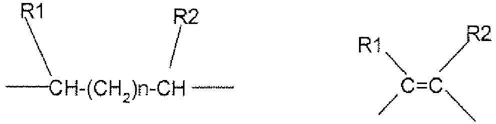 or 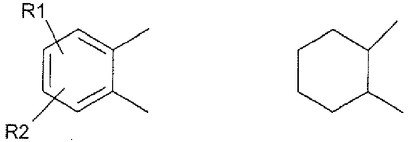 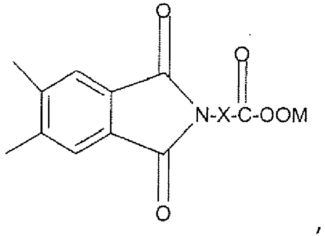 in which:
n is an integer 0, 1 or 2,
R1 has one of the following meanings: hydrogen, chlorine, bromine, C1-C20 alkyl, C2-C20 alkenyl, aryl or alkylaryl,
R2 is hydrogen, chlorine, bromine or a group chosen from the following: -SO₃M, -CO₂M, -CO₃M or -OSO₃M,
M means hydrogen, an alkali metal, ammonium or an equivalent of an alkaline-earth metal,
X indicates a C1-C19 alkylene or an arylene,
wherein the processing contains wafer cleaning conducted by bringing the composition into contact with the surface of the semiconductor wafer, or
wherein the processing contains chemical mechanical planarization (CMP) of a surface comprising bringing the composition into contact with the surface to be polished and polishing the surface by causing a friction between the surface to be polished and another polishing surface.

2. Use according to claim 1, wherein the ester peracid is a mixture of the methyl monoesters of peradipic, perglutaric and persuccinic acids, the major component of the mixture being the methyl monoester of perglutaric acid.

3. Use according to claim 1, wherein the imido-alkane-percarboxylic acid is ε-phtalimido-peroxycaproic acid.

4. Use according to claim 1, wherein the composition is in the form of a solution, preferably of an aqueous solution or a solution into an organic solvent.

5. Use according to claim 1, wherein the CMP is conducted on metal layers on semiconductor substrates, the metal being preferably chosen from aluminum, copper, tungsten, titan, alloys thereof and mixtures thereof, more preferably aluminum or copper, most preferably copper.

6. Use according to claim 5, wherein the composition is in the form of a slurry and further comprises abrasive particles, preferably in the form of an aqueous slurry or a slurry in an organic solvent.

7. Use according to any one of claims 1 to 6, wherein the total amount of oxidant present in the composition is of from 0.01 to 40% w/w.

8. Use according to any one of claims 1 to 7, wherein the ester peracid or the imido-alkane-percarboxylic acid is present in the composition in an amount of from 0.01 to 40 % w/w.

9. Use according to any one of claims 1 to 8, wherein the composition further comprises at least one material selected from chelating agents, stabilizing agents, dispersing agents, corrosion inhibitors, thickeners, pH controllers or mixtures thereof.

10. Composition in the form of a slurry suitable for chemical mechanical planarization (CMP) of a surface of a semiconductor comprising at least one oxidant selected from the group consisting of ester peracids and imido-alkane-percarboxylic acids, wherein the ester peracid has the following formula: 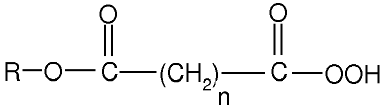 wherein:
R represents an alkyl group having 1 to 4 carbon atoms and
n is from 1 to 4;
wherein the imido-alkane-percarboxylic acid has the following formula: 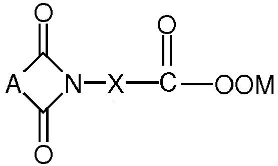 wherein: A represents a group chosen from the following: 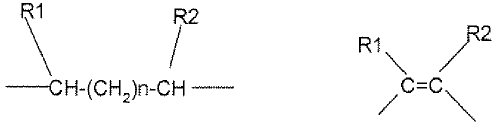 or 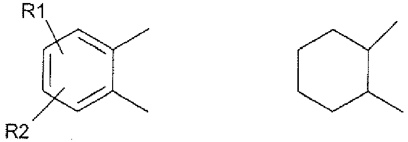 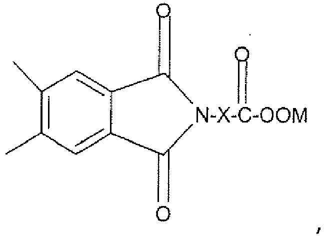 in which:
n is an integer 0, 1 or 2,
R1 has one of the following meanings: hydrogen, chlorine, bromine, C1-C20 alkyl, C2-C20 alkenyl, aryl or alkylaryl,
R2 is hydrogen, chlorine, bromine or a group chosen from the following: -SO₃M, -CO₂M, -CO₃M or -OSO₃M,
M means hydrogen, an alkali metal, ammonium or an equivalent of an alkaline-earth metal,
X indicates a C1-C19 alkylene or an arylene;
wherein the composition further comprises abrasive particles.

## Patentansprüche

1. Verwendung mindestens eines Oxidationsmittels aus der Gruppe bestehend aus Esterpersäuren und Imidoalkanpercarbonsäuren in Zusammensetzungen für die Halbleiterwaferverarbeitung, wobei die Esterpersäure die folgende Formel aufweist: 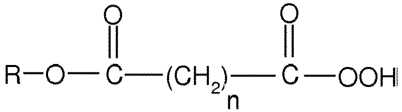 worin:
R für eine Alkylgruppe mit 1 bis 4 Kohlenstoffatomen steht und
n für 1 bis 4 steht;
wobei die Imidoalkanpercarbonsäure die folgende Formel aufweist: 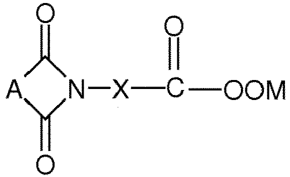 worin: A für eine Gruppe steht, die aus den folgenden Gruppen ausgewählt ist: 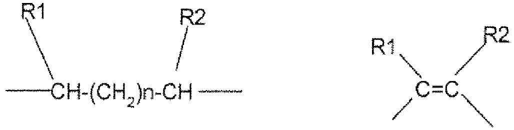 oder 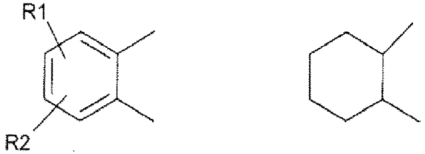 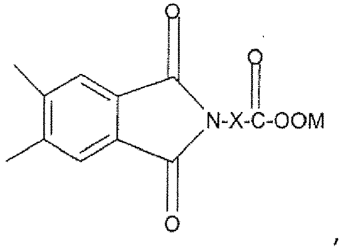 worin:
n für eine ganze Zahl mit einem Wert von 0, 1 oder 2 steht,
R1 einen der folgenden Bedeutungen besitzt: Wasserstoff, Chlor, Brom, C1-C20-Alkyl, C2-C20-Alkenyl, Aryl oder Alkylaryl,
R2 für Wasserstoff, Chlor, Brom oder eine Gruppe, die aus den folgenden Gruppen ausgewählt ist, steht: -SO₃M, -CO₂M, -CO₃M oder -OSO₃M,
M Wasserstoff, ein Alkalimetall, Ammonium oder ein Äquivalent eines Erdalkalimetalls bedeutet,
X für ein C1-C19-Alkylen oder ein Arylen steht, wobei die Verarbeitung eine Waferreinigung beinhaltet, die durchgeführt wird, indem die Zusammensetzung mit der Oberfläche des Halbleiterwafers in Kontakt gebracht wird, oder
wobei die Verarbeitung eine chemisch-mechanische Planarisierung (CMP) einer Oberfläche beinhaltet, die das Inkontaktbringen der Zusammensetzung mit der zu polierenden Oberflächen und das Polieren der Oberfläche durch Bewirken einer Reibung zwischen der zu polierenden Oberflächen und einer anderen Polieroberfläche umfasst.

2. Verwendung nach Anspruch 1, wobei es sich bei der Esterpersäure um eine Mischung der Methylmonoester von Peradipinsäure, Perglutarsäure und Perbernsteinsäure handelt, wobei es sich bei der Hauptkomponente der Mischung um den Methylmonoester von Perglutarsäure handelt.

3. Verfahren nach Anspruch 1, wobei sich bei der Imidoalkanpercarbonsäure um ε-Phthalimidoperoxycapronsäure handelt.

4. Verwendung nach Anspruch 1, wobei die Zusammensetzung in Form einer Lösung, vorzugsweise einer wässrigen Lösung oder einer Lösung in einem organischen Lösungsmittel, vorliegt.

5. Verwendung nach Anspruch 1, bei dem die CMP an Metallschichten auf Halbleitersubstraten durchgeführt wird, wobei das Metall vorzugsweise aus Aluminium, Kupfer, Wolfram, Titan, Legierungen davon und Mischungen davon, weiter bevorzugt Aluminium oder Kupfer, ganz besonders bevorzugt Kupfer, ausgewählt ist.

6. Verwendung nach Anspruch 5, wobei die Zusammensetzung in Form einer Slurry vorliegt und ferner Schleifteilchen umfasst, vorzugsweise in Form einer wässrigen Slurry oder einer Slurry in einem organischen Lösungsmittel.

7. Verwendung nach einem der Ansprüche 1 bis 6, wobei die Gesamtmenge an Oxidationsmittel in der Zusammensetzung 0,01 bis 40 Gew.-% beträgt.

8. Verwendung nach einem der Ansprüche 1 bis 7, bei die Esterpersäure oder die Imidoalkanpercarbonsäure in der Zusammensetzung einer Menge von 0,01 bis 40 Gew.-% vorliegt.

9. Verwendung nach einem der Ansprüche 1 bis 8, wobei die Zusammensetzung ferner mindestens eine Substanz umfasst, die aus Chelatbildnern, Stabilisatoren, Dispergiermitteln, Korrosionsinhibitoren, Verdickern, Mittel zur Regulierung des pH-Werts oder Mischungen davon ausgewählt ist.

10. Zusammensetzung in Form einer Slurry, die für die chemisch-mechanische Planarisierung (CMP) einer Oberfläche eines Halbleiters geeignet ist und mindestens ein Oxidationsmittel aus der Gruppe bestehend aus Esterpersäuren und Imidoalkanpercarbonsäuren in Zusammensetzungen für die Halbleiterwaferverarbeitung, wobei die Esterpersäure die folgende Formel aufweist: 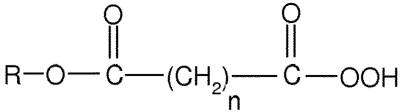 worin:
R für eine Alkylgruppe mit 1 bis 4 Kohlenstoffatomen steht und
n für 1 bis 4 steht;
wobei die Imidoalkanpercarbonsäure die folgende Formel aufweist: 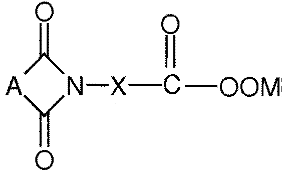 worin: A für eine Gruppe steht, die aus den folgenden Gruppen ausgewählt ist: 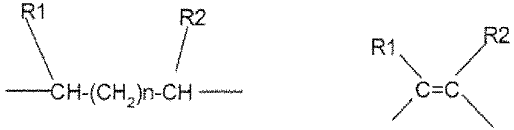 oder 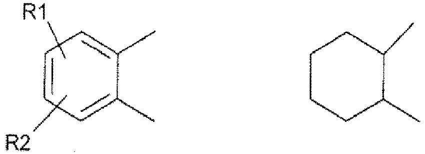 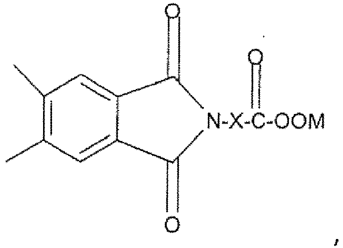 worin:
n für eine ganze Zahl mit einem Wert von 0, 1 oder 2 steht,
R1 einen der folgenden Bedeutungen besitzt: Wasserstoff, Chlor, Brom, C1-C20-Alkyl, C2-C20-Alkenyl, Aryl oder Alkylaryl,
R2 für Wasserstoff, Chlor, Brom oder eine Gruppe, die aus den folgenden Gruppen ausgewählt ist, steht: -SO₃M, -CO₂M, -CO₃M oder -OSO₃M,
M Wasserstoff, ein Alkalimetall, Ammonium oder ein Äquivalent eines Erdalkalimetalls bedeutet,
X für ein C1-C19-Alkylen oder ein Arylen steht;
wobei die Zusammensetzung ferner Schleifteilchen umfasst.

## Revendications

1. Utilisation d'au moins un oxydant choisi dans le groupe constitué par les peracides d'esters et les acides imidoalcanepercarboxyliques dans des compositions pour le traitement de tranche de semi-conducteur, dans laquelle le peracide d'ester répond à la formule suivante : 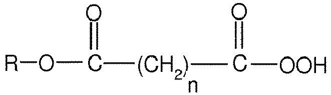 dans laquelle :
R représente un groupe alkyle ayant 1 à 4 atomes de carbone et
n va de 1 à 4 ;
dans laquelle l'acide imidoalcanepercarboxylique répond à la formule suivante : 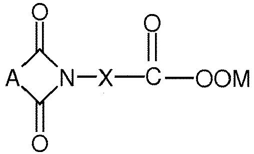 dans laquelle :
A représente un groupe choisi parmi les suivants : 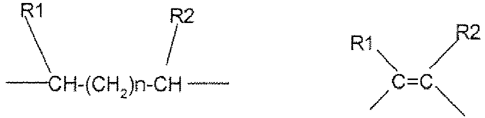
ou 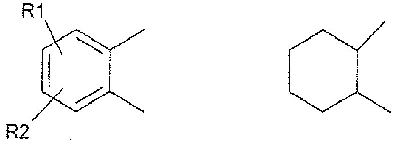 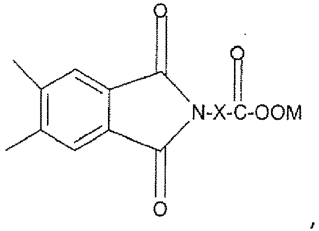 dans lesquels :
n est un nombre entier 0, 1 ou 2,
R1 a l'une des significations suivantes : l'atome d'hydrogène, de chlore ou de brome ou un groupe alkyle en C1-C20, alcényle en C2-C20, aryle ou alkylaryle,
R2 est l'atome d'hydrogène, de chlore ou de brome ou un groupe choisi parmi les suivants : -SO₃M, -CO₂M, -CO₃M ou -OSO₃M,
M désigne l'atome d'hydrogène, un métal alcalin, l'ion ammonium ou un équivalent d'un métal alcalinoterreux,
X indique un groupe alkylène en C1-C19 ou arylène,
dans laquelle le traitement comporte un nettoyage de tranche effectué par la mise en contact de la composition avec la surface de la tranche de semi-conducteur ou
dans laquelle le traitement comporte une planarisation mécano-chimique (CMP) d'une surface comprenant la mise en contact de la composition avec la surface à polir et le polissage de la surface par la provocation d'un frottement entre la surface à polir et une autre surface de polissage.

2. Utilisation selon la revendication 1, dans laquelle le peracide d'ester est un mélange des monoesters méthyliques des acides peradipique, perglutarique et persuccinique, le constituant principal du mélange étant le monoester méthylique de l'acide perglutarique.

3. Utilisation selon la revendication 1, dans laquelle l'acide imidoalcanepercarboxylique est l'acide ε-phtalimidoperoxycaproïque.

4. Utilisation selon la revendication 1, dans laquelle la composition est sous la forme d'une solution, de préférence d'une solution aqueuse ou d'une solution dans un solvant organique.

5. Utilisation selon la revendication 1, dans laquelle la CMP est effectuée sur des couches métalliques sur des substrats en semi-conducteur, le métal étant de préférence choisi parmi l'aluminium, le cuivre, le tungstène, le titane, les alliages de ceux-ci et les mélanges de ceux-ci, plus préférablement le métal étant l'aluminium ou le cuivre, le plus préférablement le cuivre.

6. Utilisation selon la revendication 5, dans laquelle la composition est sous la forme d'une suspension épaisse et comprend en outre des particules abrasives, de préférence sous la forme d'une suspension épaisse aqueuse ou d'une suspension épaisse dans un solvant organique.

7. Utilisation selon l'une quelconque des revendications 1 à 6, dans laquelle la quantité totale d'oxydant présent dans la composition est de 0,01 à 40 % p/p.

8. Utilisation selon l'une quelconque des revendications 1 à 7, dans laquelle le peracide d'ester ou l'acide imidoalcanepercarboxylique est présent dans la composition en une quantité de 0,01 à 40 % p/p.

9. Utilisation selon l'une quelconque des revendications 1 à 8, dans laquelle la composition comprend en outre au moins une substance choisie parmi les agents chélatants, les agents stabilisants, les agents dispersants, les inhibiteurs de corrosion, les épaississants, les agents d'ajustement du pH ou les mélanges de ceux-ci.

10. Composition sous la forme d'une suspension épaisse convenant pour la planarisation mécano-chimique (CMP) d'une surface d'un semi-conducteur comprenant au moins un oxydant choisi dans le groupe constitué par les peracides d'esters et les acides imidoalcanepercarboxyliques, dans laquelle le peracide d'ester répond à la formule suivante : 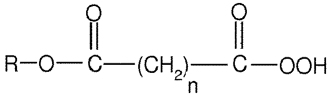 dans laquelle :
R représente un groupe alkyle ayant 1 à 4 atomes de carbone et
n va de 1 à 4 ;
dans laquelle l'acide imidoalcanepercarboxylique répond à la formule suivante : 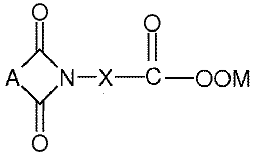 dans laquelle :
A représente un groupe choisi parmi les suivants : 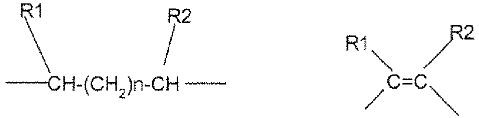
ou 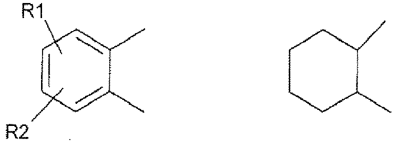 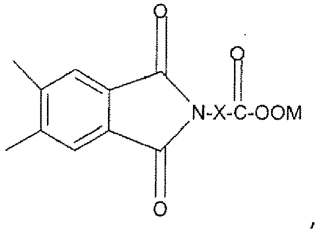 dans lesquels :
n est un nombre entier 0, 1 ou 2,
R1 a l'une des significations suivantes : l'atome d'hydrogène, de chlore ou de brome ou un groupe alkyle en C1-C20, alcényle en C2-C20, aryle ou alkylaryle,
R2 est l'atome d'hydrogène, de chlore ou de brome ou un groupe choisi parmi les suivants : -SO₃M, -CO₂M, -CO₃M ou -OSO₃M,
M désigne l'atome d'hydrogène, un métal alcalin, l'ion ammonium ou un équivalent d'un métal alcalinoterreux,
X indique un groupe alkylène en C1-C19 ou arylène ;
la composition comprenant en outre des particules abrasives.
